(19)

Europäisches
Patentamt
European
Patent Office
Office européen
des brevets

(11)     **EP 2 184 767 A2**

(12)     **EUROPEAN PATENT APPLICATION**

(43) Date of publication:
**12.05.2010  Bulletin 2010/19**

(51) Int Cl.:
**H01L 21/00** *(2006.01)*

(21) Application number: **09173595.1**

(22) Date of filing: **21.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **07.11.2008  US 267223**

(71) Applicant: **Palo Alto Research Center Incorporated**
**Palo Alto, California 94304 (US)**

(72) Inventors:
• **Fork, David K.**
  **Los Altos, CA 94024 (US)**
• **Solberg, Scott E.**
  **Los Altos, CA 94023 (US)**

(74) Representative: **Gervasi, Gemma et al**
**Notarbartolo & Gervasi GmbH**
**Bavariaring 21**
**80336 München (DE)**

(54)     **Micro-extrusion system with airjet assisted bead deflection**

(57)     A micro-extrusion system and a method for producing a plurality of beads of extrusion material on an upper surface of a target substrate is disclosed. The micro-extrusion system comprises an extrusion print-head assembly including an inlet port, a plurality of nozzle openings, and one or more flow channels, each of the one or more flow channels communicating between said inlet port and an associated one of said plurality of nozzle openings, a material feed system for supplying said extrusion material to said inlet port such that said extrusion material is forced through said one or more flow channels and exits through said plurality of nozzle openings, thereby producing said plurality of beads of extrusion material, means for supporting the extrusion printhead assembly and said target substrate, and for moving the extrusion printhead assembly relative to said target substrate such that extrusion material exiting said plurality of nozzle openings causes said plurality of beads to form parallel lines of extrusion material on the upper surface of the target substrate, and means for directing a gas against said plurality of beads such that said gas pushes said plurality of beads toward the target substrate.

FIG. 1

EP 2 184 767 A2

**Description**

DETAILED DESCRIPTION

The present invention relates to an improvement in micro-extrusion systems. The following description is presented to enable one of ordinary skill in the art to make and use the invention as provided in the context of a particular application and its requirements. As used herein, directional terms such as "upper", "top", "lower", "bottom", "front", "rear", and "lateral" are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

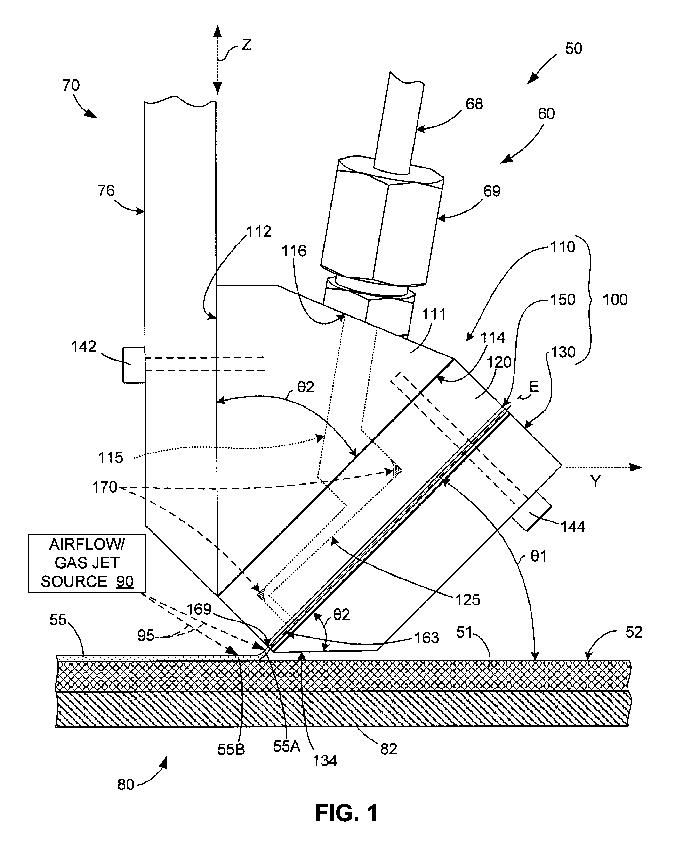

Fig. 1 is a simplified side view showing a portion of a generalized micro-extrusion system 50 for forming parallel extruded material lines 55 on upper surface 52 of a substrate 51. Micro-extrusion system 50 includes an extrusion printhead assembly 100 that is operably coupled to a material feed system 60 by way of at least one feedpipe 68 and an associated fastener 69. The materials are applied through pushing and/or drawing techniques (e.g., hot and cold) in which the materials are pushed (e.g., squeezed, etc.) and/or drawn (e.g., via a vacuum, etc.) through extrusion printhead assembly 100, and out one or more outlet orifices (nozzle openings) 169 that are respectively defined in a lower portion of printhead assembly 100. Micro-extrusion system 50 also includes a X-Y-Z-axis positioning mechanism 70 including a mounting plate 76 for rigidly supporting and positioning printhead assembly 100 relative to substrate 51, and a base 80 including a platform 82 for supporting substrate 51 in a stationary position as printhead assembly 100 is moved in a predetermined (e.g., Y-axis) direction over substrate 51. In alternative embodiment (not shown), printhead assembly 100 is stationary and base 80 includes an X-Y axis positioning mechanism for moving substrate 51 under printhead assembly 100.

In accordance with the present invention, micro-extrusion system 50 also includes an airflow/gas jet source 90 that is positioned downstream from nozzle openings 169 and served to direct a gas 95 (e.g., air or dry nitrogen) either onto beads 55 immediately after leaving printhead assembly 100 (i.e., portion 55A located between nozzle opening 169 and substrate 51), or immediately after beads 55 have landed on substrate 51 (i.e., portion 55B located on substrate 51). As described in additional detail below, in both cases gas 95 serves to push beads 55 toward substrate 51, thereby either addressing the bead direction problem mentioned above by pushing beads 55 toward substrate 51, or by flattening beads 55 against the substrate surface 52 using pressurized gas.

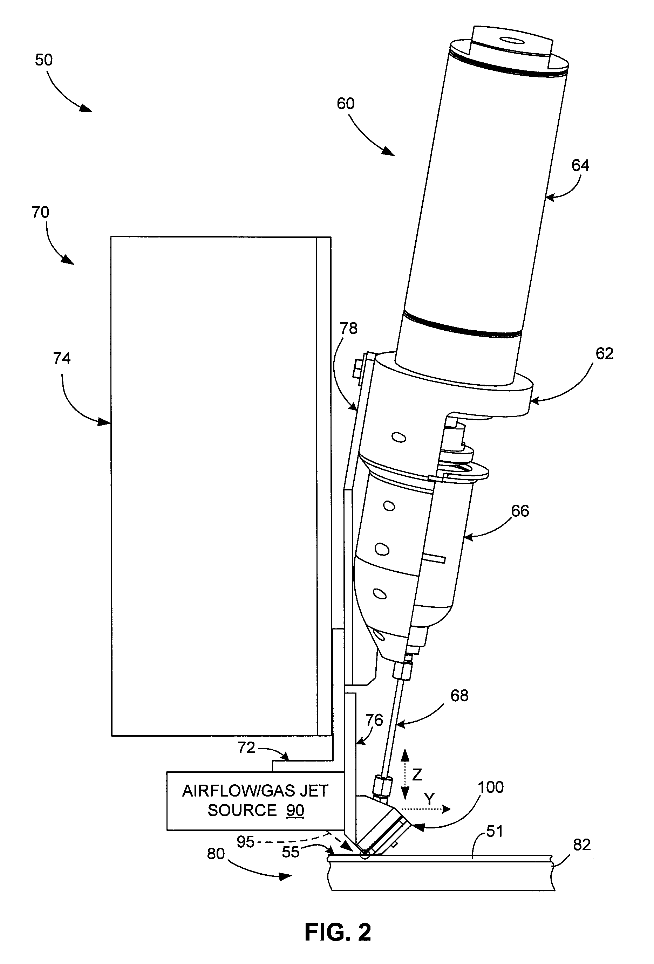

Fig. 2 shows material feed system 60, X-Y-Z-axis positioning mechanism 70 and base 80 of micro-extrusion system 50 in additional detail. The assembly shown in Fig. 2 represents an experimental arrangement utilized to produce solar cells on a small scale, and those skilled in the art will recognize that other arrangements would typically be used to produce solar cells on a larger scale. Referring to the upper right portion of Fig. 2, material feed system 60 includes a housing 62 that supports a pneumatic cylinder 64, which is operably coupled to a cartridge 66 such that material is forced from cartridge 66 through feedpipe 68 into printhead assembly 100. Referring to the left side of Fig. 2, X-Y-Z-axis positioning mechanism 70 includes a Z-axis stage 72 that is movable in the Z-axis (vertical) direction relative to target substrate 51 by way of a housing/actuator 74 using known techniques. Mounting plate 76 is rigidly connected to a lower end of Z-axis stage 72 and supports printhead assembly 100, and a mounting frame 78 is rigidly connected to and extends upward from Z-axis stage 72 and supports pneumatic cylinder 64 and cartridge 66. Referring to the lower portion of Fig. 2, base 80 includes supporting platform 82, which supports target substrate 51 as an X-Y mechanism moves printhead assembly 100 in the X-axis and Y-axis directions (as well as a couple of rotational axes) over the upper surface of substrate 51 utilizing known techniques.

Referring to the lower portion of Fig. 2, in accordance with an embodiment of the present invention, airflow/gas jet source 90 is fixedly mounted to Z-axis stage 72 such that airflow/gas jet source 90 is held in a fixed relationship relative to extrusion printhead assembly 100 while directing gas 95 onto bead 55. In an alternative embodiment (not shown), airflow/gas jet source 90 may be supported by a structure separate from Z-axis stage 72, although this arrangement may be unnecessarily complicated.

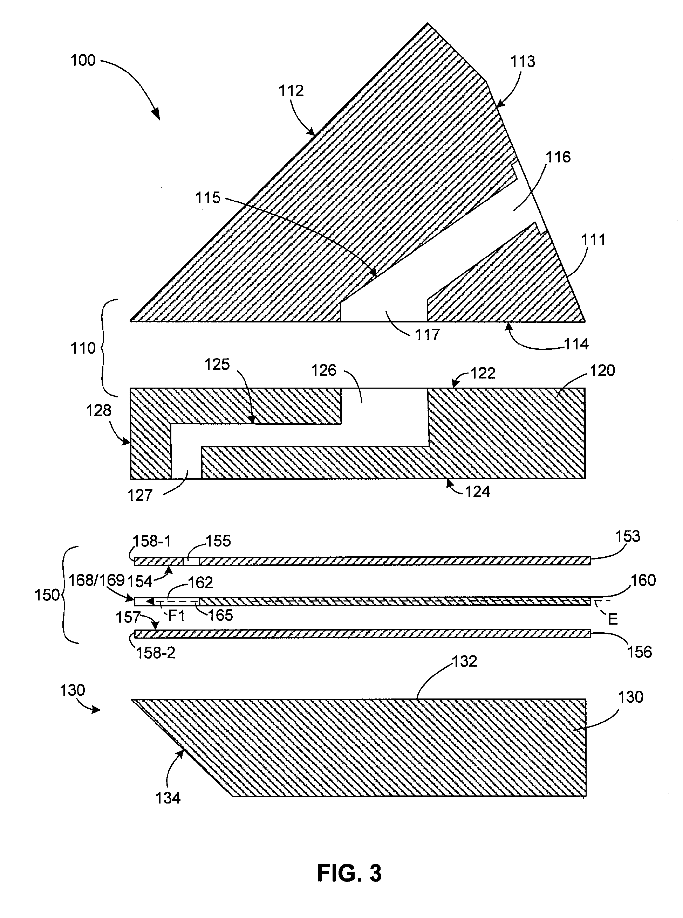

As shown in Fig. 1 and in exploded form in Fig. 3, layered micro-extrusion printhead assembly 100 includes a first (back) plate structure 110, a second (front) plate structure 130, and a layered nozzle structure 150 connected therebetween. Back plate structure 110 and front plate structure 130 serve to guide the extrusion material from an inlet port 116 to layered nozzle structure 150, and to rigidly support layered nozzle structure 150 such that extrusion nozzles 163 defined in layered nozzle structure 150 are pointed toward substrate 51 at a predetermined tilted angle $\theta 1$ (e.g., 45°), whereby extruded material traveling down each extrusion nozzle 163 toward its corresponding nozzle orifice 169 is directed toward target substrate 51.

Each of back plate structure 110 and front plate structure 130 includes one or more integrally molded or machined metal parts. In the disclosed embodiment, back plate structure 110 includes an angled back plate 111 and a back plenum 120, and front plate structure 130 includes a single-piece metal plate. Angled back plate 111 includes a front surface 112, a side surface 113, and a back surface 114, with front surface 112 and back surface 114 forming a predetermined angle θ2 (e.g., 45°; shown in Fig. 1). Angled back plate 111 also defines a bore 115 that extends from a threaded countersunk bore inlet 116 defined in side wall 113 to a bore outlet 117 defined in back surface 114. Back plenum 120 includes parallel front surface 122 and back surface 124, and defines a conduit 125 having an inlet 126 defined through front surface 122, and an outlet 127 defined in back surface 124. As described below, bore 115 and plenum 125 cooperate to feed extrusion material to layered nozzle structure 150. Front plate structure 130 includes a front surface 132 and a beveled lower surface 134 that form predetermined angle θ2 (shown in Fig. 1).

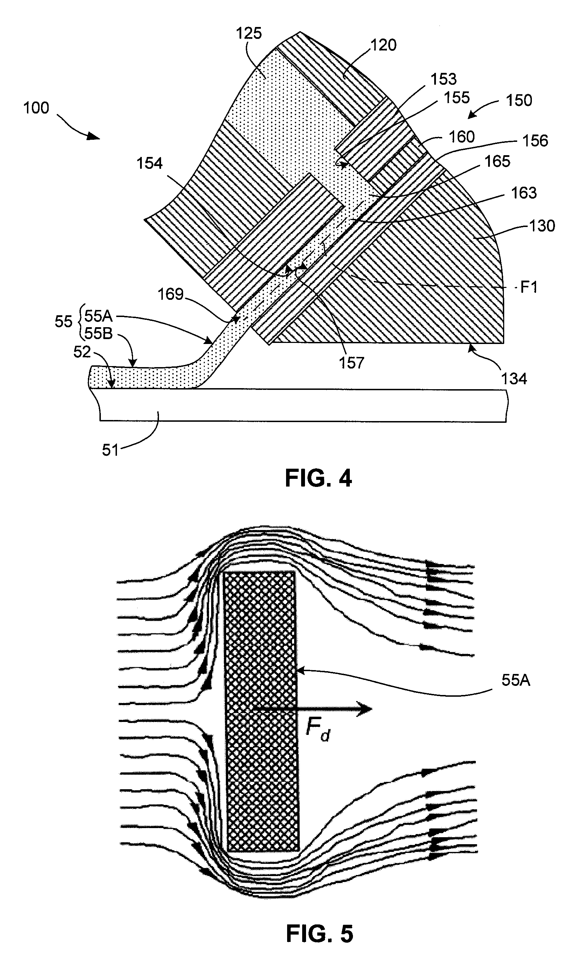

Layered nozzle structure 150 includes two or more stacked plates (e.g., a metal such as aluminum, steel or plastic that combine to form one or more extrusion nozzles 163. In the embodiment shown in Fig. 3, layered nozzle structure 150 includes a top nozzle plate 153, a bottom nozzle plate 156, and a nozzle outlet plate 160 sandwiched between top nozzle plate 153 and bottom nozzle plate 156. Top nozzle plate 153 defines an inlet port (through hole) 155, and has a (first) front edge 158-1. Bottom nozzle plate 156 is a substantially solid (i.e., continuous) plate having a (third) front edge 158-2. Nozzle outlet plate 160 includes a (second)front edge 168 and defines an elongated nozzle channel 162 extending in a predetermined first flow direction F1 from a closed end 165 to an nozzle orifice 169 defined through front edge 168. When operably assembled (e.g., as shown in Fig. 4), nozzle outlet plate 160 is sandwiched between top nozzle plate 153 and bottom nozzle plate 156 such that elongated nozzle channel 162, a front portion 154 of top nozzle plate 153, and a front portion 157 of bottom nozzle plate 156 combine to define elongated extrusion nozzle 163 that extends from closed end 165 to nozzle orifice 169. In addition, top nozzle plate 153 is mounted on nozzle outlet plate 160 such that inlet port 155 is aligned with closed end 165 of elongated channel 162, whereby extrusion material forced through inlet port 155 flows in direction F1 along extrusion nozzle 163, and exits from layered nozzle structure 150 by way of nozzle orifice 169 to form bead 55 on substrate 51.

Referring again to Fig. 1, when operably assembled and mounted onto micro-extrusion system 50, angled back plate 111 of printhead assembly 100 is rigidly connected to mounting plate 76 by way of one or more fasteners (e.g., machine screws) 142 such that beveled surface 134 of front plate structure 130 is positioned close to parallel to upper surface 52 of target substrate 51. One or more second fasteners 144 are utilized to connect front plate structure 130 to back plate structure 110 with layered nozzle structure 150 pressed between the back surface of front plate structure 130 and the back surface of back plenum 120. In addition, material feed system 60 is operably coupled to bore 115 by way of feedpipe 68 and fastener 69 using known techniques, and extrusion material forced into bore 115 is channeled to layered nozzle structure 150 by way of conduit 125.

In a preferred embodiment, as shown in Fig. 1, a hardenable material is injected into bore 115 and conduit 125 of printhead assembly 100 in the manner described in co-owned and co-pending US Patent Application Serial No. 12/267,147 entitled "DEAD VOLUME REMOVAL FROM AN EXTRUSION PRINTHEAD". This hardenable material forms portions 170 that fill any dead zones of conduit 125 that could otherwise trap the extrusion material and lead to clogs.

Fig. 4 is a simplified cross-sectional side view showing a portion of a printhead assembly 100 during operation. As shown in Fig. 4, extrusion material exiting conduit 125 enters the closed end of nozzle 163 by way of inlet 155 and closed end 165 (both shown in Fig. 3) of nozzle 163, and flows in direction F1 down nozzle 163 toward outlet 169. Referring to Fig. 4, the extrusion material flowing in the nozzle 163 is directed through the nozzle opening 169. As described herein, a "flying" portion 55A of bead 55 disposed immediately after ejection (i.e., before striking upper surface 52 of substrate 51) is identified separately from a "landed" portion 55B of bead 55 is disposed on upper surface 52 for reasons that are described below. Referring back to Fig. 1, the extruded material is guided at the tilted angle θ2 as it exits nozzle orifice 169, thus being directed toward substrate 51 in a manner that facilitates high volume solar cell production.

According to a first series of embodiments, the present invention is specifically directed to techniques for generating an air flow or gas jet onto portion 55A of bead 55 such that bead 55 is reliably deflected down onto substrate 51 as it exits from the dispense nozzle. Referring to Fig. 5, the principal force used to deflect "flying" bead portion 55A is the aerodynamic drag force of the air encountering bead portion 55A in the air flow path. The drag force occurs in the direction of air flow. A secondary force that may come into play is the lift force, which will not be considered for the estimates below. A rough approximation of the drag force $F_d$ on a object is expressed as set in Equation 1:

$$F_d = \frac{1}{2}\rho v^2 C_d A$$

Equation 1

In equation 1, ρ is the density of air, $v$ is the air velocity, $C_d$ is the drag coefficient, and $A$ is the cross sectional area of the object. Equation 1 is valid when the wake behind an object (e.g., "flying" bead portion 55A) is turbulent. A rough estimate of the deflection of bead portion 55A is provided by considering bead portion 55A as an elastic cantilever of length *l*, thickness *t* and width *w*. In this case the spring constant *k* of the bead portion 55A as it pokes out from the nozzle orifice may be expressed by Equation 2:

$$k = \frac{Y w t^3}{4 l^3}$$

Equation 2

where Y is the elastic modulus of bead portion 55A, which is on the order of 1000 Pa. Typical bead width and thickness are 250 and 100 microns, respectively. If one desires to deflect bead portion 55A by 50 microns as it emerges by 100 microns from the nozzle orifice, the above relations provide an estimate that an air velocity on the order of 10 m/sec is required. This level of air flow is readily achieved with modest air pressures and easily fabricated air delivery apparatus, examples of which are provided below.

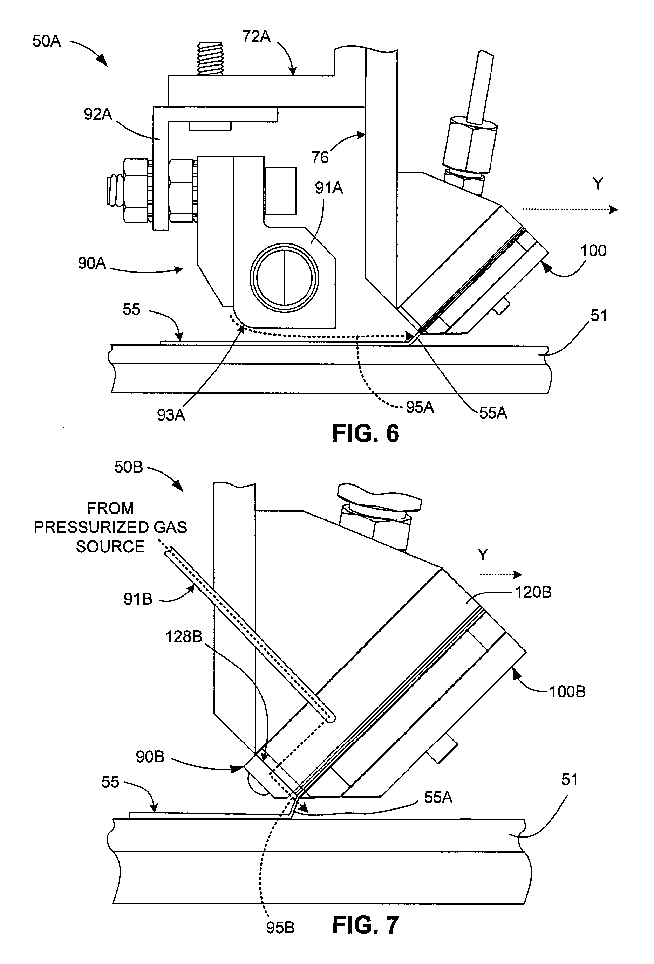

Fig. 6 is a side view showing a portion of a micro-extrusion system 50A according to a first specific embodiment in which an air knife 90A is utilized to direct a remote air flow (indicated by dashed line 95A) against "flying" bead portion 55A such that bead 55 is reliably forced onto substrate 51 as it emerges from printhead assembly 100. Air knife 90A includes a block 91A that is attached to Z-axis stage 72 by way of a bracket 92A such that a curved surface 93A is supported over substrate 51. Air knife 90A takes in a flow of compressed air (not shown) and sends the air out through a narrow slot (not shown) located just above curved surface 93A. The air stream coming out of the slot suck in additional ambient air as block 91A is moved relative to the upper surface of substrate 51 in the Y-axis direction, and directs the air toward printhead assembly 100, thereby directing a desired air flow 95A onto "flying" portions 55A of each said bead 55. In one embodiment, air knife 90A is replaced with a simple wing-like air foil in which curved surface 93A forces air downward and toward printhead assembly 100 as printhead assembly 100 is moved relative to substrate 51.

Fig. 7 is a side view showing a portion of a micro-extrusion system 50B according to a second specific embodiment in which a pressurized gas (e.g., dry nitrogen) is introduced into a gas jet array 90B from a source (not shown) by way of a pipe 91B, where gas jet array 90B redirects the pressurized gas (e.g., as indicated by dashed-line arrow 95B in Fig. 7) onto "flying" portions 55A of each bead 55 while printhead assembly 100B is moved in the Y-axis direction relative to target substrate 51. In the disclosed embodiment, printhead assembly 100B is slightly modified from the structures described above in that a back plenum 120B, which otherwise functions as described above is modified to fixedly support gas jet array 90B, and to channel pressurized gas from pipe 91B to the gas jets (described below) provided on gas jet array 90B.

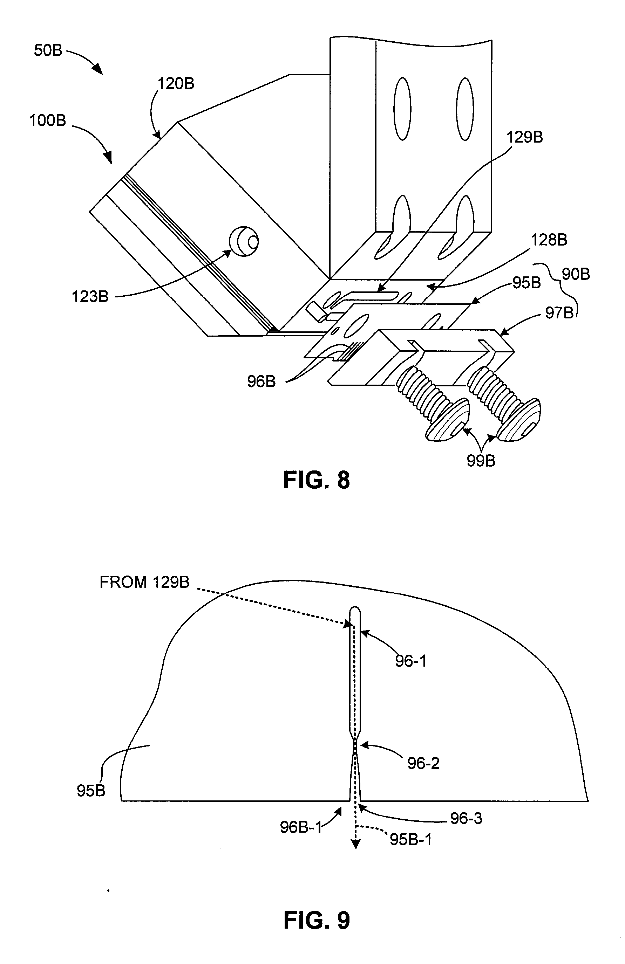

Fig. 8 is a partial exploded perspective view showing gas jet array 90B and printhead assembly 100B in additional detail. As indicated, back plenum 120B includes a threaded inlet 123B that receives pressurized gas from pipe 91B (see Fig. 7). The pressurized air passes through a channel (not shown) that communicates with one or more elongated outlets 129B. Gas jet array 90B includes a material sheet (e.g., metal or Cirlex, which is a form of polyimide) that is clamped against back surface 128B by way of a back plate structure 97B, with alignment pins being employed to ensure that the air jets are aligned to intersect the nozzle orifices with precise registration. Note that the direction of air flow leaving the jets is at a large angle relative to the direction of ink flow leaving the printhead, which helps to ensure that the drag force is maximized. This arrangement has the advantage that less gas is used, and less gas flow is directed onto the substrate (not shown), since air flow under the bead can prevent the bead from landing on and sticking to the substrate.

Fig. 9 is an enlarged view showing an exemplary jet nozzle 96B-1 of the array shown in Fig. 9 according to an embodiment of the present invention. Jet nozzle 96B-1 receives pressurized gas from elongated opening 129B at its closed end 96-1, and includes a converging/diverging neck region 96-2 between closed end 96-1 and outlet opening 96-3, from which an associated air jet portion 95B-1 is emitted. This converging/diverging architecture serves to collimate the exiting flow of air.

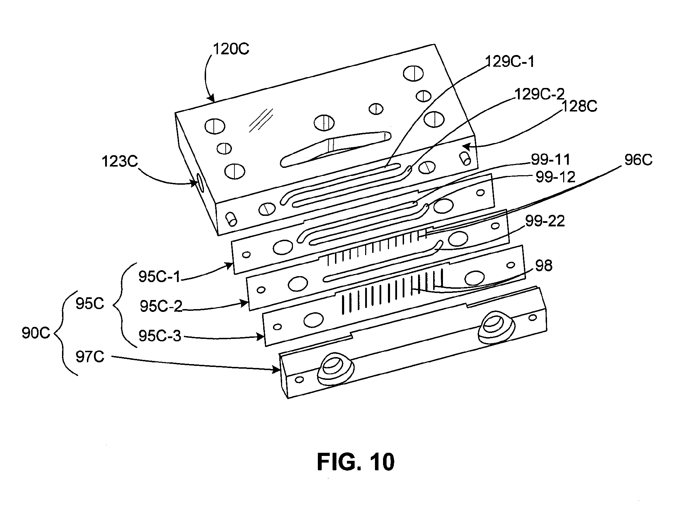

Fig. 10 is an exploded perspective view showing a portion of a micro-extrusion system 50C including a plenum 120C and a gas jet array 90C according to yet another embodiment of the present invention. Similar to the embodiment described above, pressurized air enters through an opening 123C and passes through a channel (not shown) that communicates with elongated outlets 129C-1 and 129C-2. In this embodiment, gas jet array 90B includes a jet assembly 95C including a spacer layer 95C-1, a nozzle pair array layer 95C-2, and a connecting channel layer 95C-3 that are clamped against surface 128C of back plenum 120C by way of a clamp suture 97C. Gas jet array 90B also differs from the embodiment described above with reference to Figs. 7 and 8 in that associated pairs of air jets 96C are directed at each nozzle opening (not shown) in order to provide controllable sideways deflection and torsional deflection of the extruded bead. Air jet pairs 96C are formed on a nozzle pair array layer (metal sheet) 95C-2, which is sandwiched between a spacer layer 95C-1 and a connecting channel layer 95C-2. During operation, pressurized gas is supplied to a first jet of each jet nozzle pair 96C by way of outlet 129B-1 and opening 99-11 defined in spacer layer 95C-1, and to the second jet of each jet nozzle pair 96C by way of outlet 129B-2, opening 99-12 defined in spacer layer 95C-1, opening 99-22 defined in nozzle pair array layer 95C-2, and vertical slots 98 defined in connecting channel layer 95C-2.

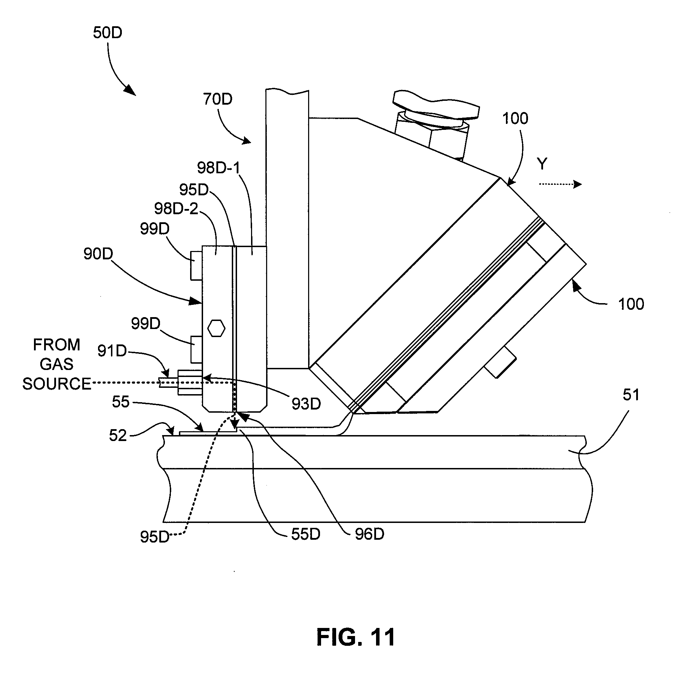

Fig. 11 is a simplified side view showing a portion of a micro-extrusion system 50D according to another embodiment of the present invention. Micro-extrusion system 50D includes a Z-axis positioning mechanism 70D and printhead assembly 100 and other features similar to those described above, but differs in that it also includes a gas jet array 90D that is mounted onto Z-axis positioning mechanism 70D such that gas jet array 90D directs pressurized gas (e.g., air, dry nitrogen, or other gas phase fluid) 95D downward onto a portion 55B of extruded beads (lines) 55 immediately after portion 55B has contacted upper surface 52 of target substrate 51 (i.e., while the extruded material is still "wet"). Gas jet array 90D includes clamp portions 98D-1 and 98D-2 disposed on opposite sides of one or more metal air jet plates 95D that are formed similar to the air jet arrangements described above with reference to Figs. 8 and 10, and are secured to Z-axis positioning mechanism 70D by way of screws 99D. As indicated, back clamp portion 98D-2 includes a threaded inlet 93D that receives pressurized gas by way of a pipe 91D. The pressurized gas passes through a channel (not shown) that communicates with one or more elongated nozzle outlets 96D. By directing pressurized gas 95D downward onto portion 55B, system 50D facilitates the high throughput printing of thin, low aspect ratio lines 55 on substrate 51. That is, pressurized gas 95D applies sufficient force to flatten (slump) portion 55B toward substrate surface 52, thereby facilitating the formation of wide and flat lines of material using a relatively narrow and tall extrusion nozzles. With this technique, a single bead can be expanded to many times its deposited width. For example, with this arrangement, the inventors have found it possible to flatten (slump) extrusion material lines 55 from a width of about 0.4 mm to a width of greater than 2 mm and a wet thickness of 0.010 to 0.020 mm. With the loading and viscosity of the ink used for extrusion printing it would be impossible to produce lines of these dimensions directly, even by allowing large amounts of time for the ink to slump under gravitational and wetting forces (in this regard, a practical consideration is that standard production flow between the printing of buss bars 45 and the printing of gridlines 44 only allows about three seconds or less between the buss bar print and the grid line print). In addition, as set forth below, this technique is selectively utilized to create reliable connections between the gridline endpoints and the substrate in H-pattern solar cells, and is also utilized to selectively flatten the cell topography to facilitate stronger solder joints between buss bars and metal ribbons.

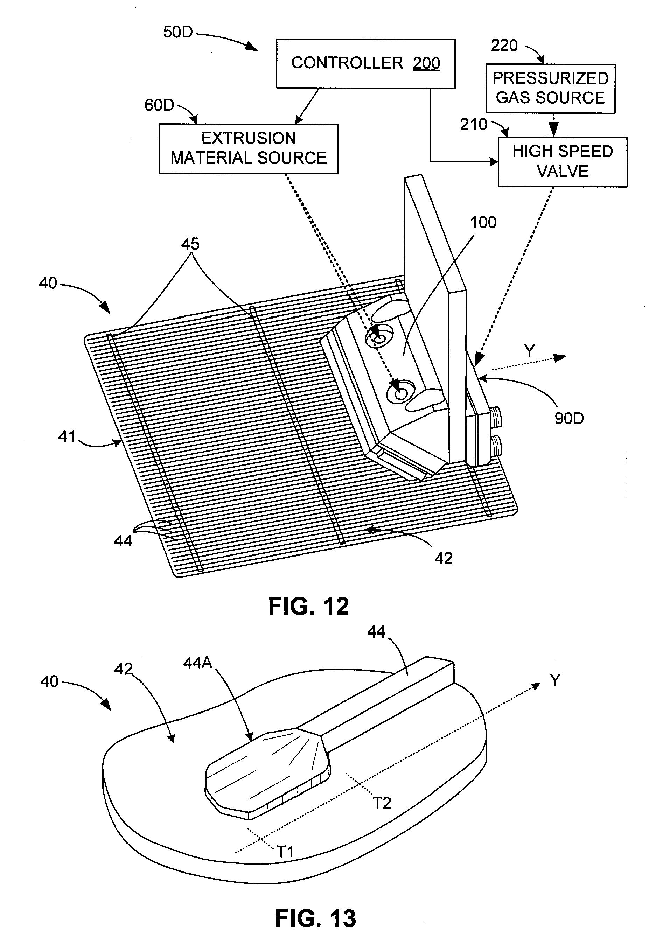

Fig. 12 is a modified perspective view showing a portion of micro-extrusion system 50D during operation in the production of an H-pattern solar cell 40 similar to that described above in the background section. According to another aspect of the present invention, micro-extrusion system 50D includes a controller 200 (e.g., a microprocessor) that is programmed to both a control extrusion material source 60D to facilitate selective extrusion of material onto substrate 41 by way of printhead 100, and one or more high speed valves 210 that is coupled to a pressurized gas source 220 to selectively control the generation of gas jets by way of gas jet array 90D. As described below, high speed valves 210 are used to pulse the gas pressure at selected times to produce flattening of selected sections of the extruded material structures (lines).

Fig. 13 is an enlarged partial perspective view showing a gridline endpoint 44A of an H-pattern solar cell 40 that is flattened (slumped) according to an embodiment of the present invention utilizing the arrangement shown in Fig. 12. Adherence of gridlines 44 can be enhanced by increasing the contact area of endpoints 44A. It is an aspect of this invention that gas jets are used to actively slump endpoints 44A of gridlines 44 to create larger contact areas. In this regard, as the printhead assembly 100 passes over substrate 41 in the manner shown in Fig. 12, extrusion material source 60D is actuated using control signals sent from controller 200 according to known techniques to begin extruding gridline material on substrate 41. During a time period between time T1 and time T2 (i.e., a moment later when gas jet array 90D has moved in the Y-axis direction over endpoints 44A), controller 300 sends an actuation control signal to high speed valve 210, causing high speed valve 210 to open briefly to pass a pulse (short burst) of high pressure gas from pressurized gas source 220 that coincides with the proper positioning of endpoints 44A under the gas jets, thereby producing the flattening (slumping) shown in Fig. 13.

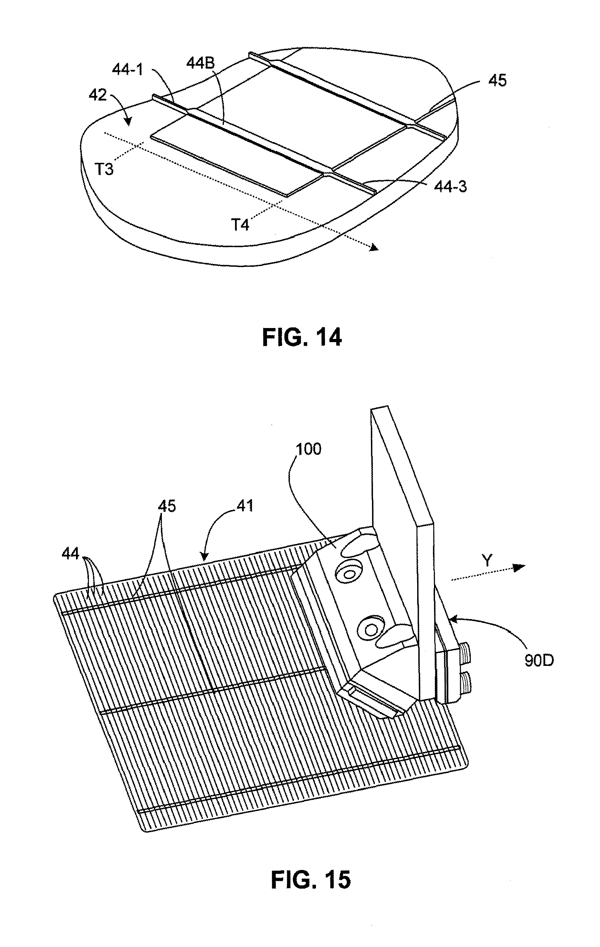

In accordance with another embodiment of the present invention, the gas jet assisted slumping described above is utilized to flatten out the topography on buss bars 45 at the vertices between buss bars 45 and gridlines 44. Referring to Fig. 14, system 50D (see Fig. 12) is utilized in the manner described above to generate pulses of pressurized gas between times T3 and T4, coinciding with the positioning of the gas jet array over sections 44B of each gridline 44 (i.e., a portion that is located on buss bar 45). As mentioned above, by mounting gas jet array 90D immediately behind printhead assembly 100, the gas pulses are delivered onto the buss bar-gridline vertices in order to flatten out the topography (i.e., such that the uppermost surface of section 44B is substantially equal to the upper surface of "unslumped" sections 44-1 and 44-2) while the extruded gridline material (ink) is in a wet state. This way, undesirable slumping of gridlines 44 in the broad area of the cell is avoided.

Fig. 15 is a partial perspective view showing an alternative gridline flattening operation in which substrate 41 is turned after gridlines 44 are printed (i.e., such that the Y-axis traveling direction of printhead assembly 100 is parallel to buss lines 45), and only the gas jets located over buss lines 45 are actuated, thereby producing a desired flattened topography similar to that shown in Fig. 14.

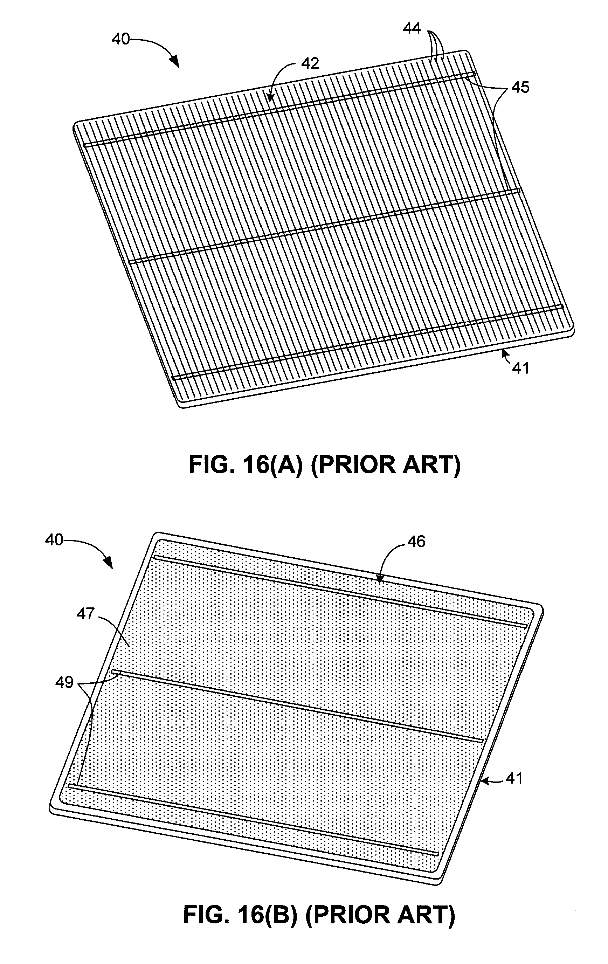

According to another embodiment, an alternative gridline flattening operation similar to that described above is used to produce back surface features using the extrusion techniques described above (i.e., as opposed to conventional screen printing techniques). The target thickness for the back side metallization is in the range of .005 to .030 mm thick after firing. According to an embodiment of the present invention, the back surface structure (e.g., similar to that shown in Fig. 16(B)) is produced by first depositing many separate beads of silver and aluminum paste, and then using one or more gas jets or gas curtains to slump and merge the beads together on the substrate to produce a connected structure. In the preferred embodiment, the separate beads of silver and aluminum are deposited by extrusion printing. In the preferred embodiment, the beads of silver and aluminum ink are deposited on a single co-extrusion printing apparatus capable of printing both aluminum and silver inks simultaneously, obviating the need for two separate printers and an intervening drying step as is currently practiced.

In accordance with a preferred embodiment, the various gas jet arrangements described above are used in combination with single extrusion and co-extrusion printhead assemblies with directional extruded bead control, such as those described in co-owned and co-pending U.S. Patent Application Serial No. 12/267,069, entitled "DIRECTIONAL EXTRUDED BEAD CONTROL".

In an alternative embodiment, one or more of the above-described embodiments may be enhanced using an arrangement in which the bead of ink includes a material that can be attracted by electrostatic force to the substrate. By applying a voltage V between the substrate and the printhead assembly across a printhead separation d, a bead of ink of width w and length 1 will experience a force F expressed by Equation 3:

$$F = \frac{\varepsilon_0 wl V^2}{2d} \qquad \text{Equation 3}$$

where $\varepsilon_0$ is the air gap (vacuum) permittivity. The voltage $V$ is limited by the breakdown strength of air (3 kV/mm) to about 1000 Volts. Deflections on the order of 10 nm are feasible with this level of electrostatic actuation.

Although the present invention has been described with respect to certain specific embodiments, it will be clear to those skilled in the art that the inventive features of the present invention are applicable to other embodiments as well, all of which are intended to fall within the scope of the present invention. For example, a spacer may be placed between the air jet nozzle and the printhead facet in order to reduce dispersive drag on the air jet.

**Claims**

1. A micro-extrusion system for producing a plurality of beads of extrusion material on an upper surface of a target substrate, the micro-extrusion system comprising:

    an extrusion printhead assembly including an inlet port, a plurality of nozzle openings, and one or more flow channels, each of the one or more flow channels communicating between said inlet port and an associated one of said plurality of nozzle openings;
    a material feed system for supplying said extrusion material to said inlet port such that said extrusion material is forced through said one or more flow channels and exits through said plurality of nozzle openings, thereby producing said plurality of beads of extrusion material;
    means for supporting the extrusion printhead assembly and said target substrate, and for moving the extrusion printhead assembly relative to said target substrate such that extrusion material exiting said plurality of nozzle openings causes said plurality of beads to form parallel lines of extrusion material on the upper surface of the target substrate; and
    means for directing a gas against said plurality of beads such that said gas pushes said plurality of beads toward the target substrate.

2. The micro-extrusion system according to Claim 1, wherein said means for directing said gas against said plurality of beads comprises means for directing a pressurized gas against each said bead.

3. The micro-extrusion system according to Claim 2, wherein said means for supporting the extrusion printhead assembly comprises a Z-axis positioning mechanism, and wherein said means for directing said pressurized gas against each said bead is fixedly connected to said Z-axis positioning mechanism.

4. The micro-extrusion system according to Claim 2, wherein said means for directing said pressurized gas against each said bead comprises means for directing said pressurized gas against a portion of said each bead that is disposed on the target substrate, whereby said portion is flattened against said substrate.

5. The micro-extrusion system according to Claim 1, wherein said means for directing said gas against said plurality of beads comprises means for directing said gas against portions of said plurality of beads that are disposed on the target substrate, whereby said portions are flattened toward said substrate.

6. The micro-extrusion system according to Claim 5, wherein said means for directing said gas against portions of said plurality of beads that are disposed on the target substrate comprises means for selectively applying a pressurized gas against said portions.

7. The micro-extrusion system according to Claim 6, wherein said means for selectively applying a pressurized gas comprises a high speed valve.

8. A method for extruding an extrusion material on an upper surface of a target substrate, the method comprising:

supplying said extrusion material to an inlet port of an extrusion printhead assembly having a plurality of nozzle openings and one or more flow channels arranged such that each of the one or more of flow channels communicates between said inlet port and an associated one of said plurality of nozzle openings;, wherein said extrusion material is supplied to said inlet port inlet port such that said extrusion material is forced through said one or more of flow channels and exits through said plurality of nozzle openings, thereby producing a plurality of beads of said extrusion material;
supporting the extrusion printhead assembly and said target substrate, and moving the extrusion printhead assembly relative to said target substrate such that extrusion material exiting said plurality of nozzle openings causes said plurality of beads to form parallel lines of extrusion material on the upper surface of the target substrate; and
directing a gas against said plurality of lines such that said gas pushes said plurality of lines toward the target substrate.

9. The method according to Claim 8, directing said gas comprises directing said gas onto a portion of each said bead that is disposed on the target substrate, whereby said portion is flattened toward said substrate.

10. The method according to Claim 9, wherein directing said gas onto said portion of each said bead comprises controlling a high speed valve to selectively apply said gas on selected regions of said portion.

11. The method according to Claim 10, wherein controlling the high speed valve comprises causing said gas to flatten end points of each of said plurality of lines.

12. The method according to Claim 10, wherein controlling the high speed valve comprises causing said gas to flatten selected central sections of said plurality of lines.

**FIG. 1**

AIRFLOW/GAS JET
SOURCE 90

**FIG. 2**

**FIG. 3**

**FIG. 4**

**FIG. 5**

FIG. 6

FROM
PRESSURIZED GAS
SOURCE

FIG. 7

50B

120B

100B

123B

129B

128B

90B

95B

97B

96B

99B

**FIG. 8**

FROM 129B

96-1

96-2

95B

96B-1

96-3

95B-1

**FIG. 9**

**FIG. 10**

14

**FIG. 11**

50D

CONTROLLER 200

220

PRESSURIZED
GAS SOURCE

60D

EXTRUSION
MATERIAL SOURCE

210

HIGH SPEED
VALVE

100

45

40

Y

41

90D

44

42

**FIG. 12**

44

40

42    44A

Y

T2

T1

**FIG. 13**

**FIG. 14**

**FIG. 15**

**FIG. 16(A) (PRIOR ART)**

**FIG. 16(B) (PRIOR ART)**

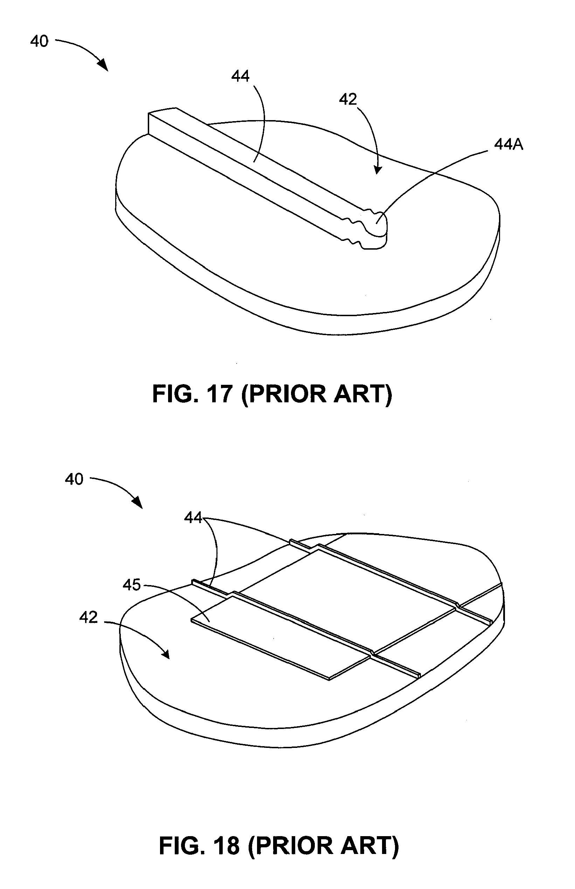

**FIG. 17 (PRIOR ART)**

**FIG. 18 (PRIOR ART)**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 267147 A
- US 267069 A